# EUROPÄISCHE PATENTSCHRIFT

(11) **EP 0 946 985 B1**
(45) Veröffentlichungstag und Bekanntmachung des Hinweises auf die Patenterteilung: **16.08.2001**
(21) Anmeldenummer: 97951797.6
(22) Anmeldetag: 20.11.1997
(51) Int. Cl.: H01L 27/115, H01L 21/8247, H01L 29/792

(54) **SPEICHERZELLENANORDNUNG UND VERFAHREN ZU DEREN HERSTELLUNG**
MEMORY CELL ARRANGEMENT AND PROCESS FOR MANUFACTURING THE SAME
AGENCEMENT DE CELLULES DE MEMOIRE ET SON PROCEDE DE FABRICATION

(30) Priorität: 17.12.1996 DE 19652547
(43) Veröffentlichungstag der Anmeldung: 06.10.1999
(73) Patentinhaber: Infineon Technologies AG, 81669 München (DE)
(72) Erfinder: HOFMANN, Franz, D-80995 München (DE); WILLER, Josef, D-85521 Riemerling (DE); REISINGER, Hans, D-82031 Grünwald (DE); VON BASSE, Paul-Werner, D-82515 Wolfratshausen (DE); KRAUTSCHNEIDER, Wolfgang, D-83104 Hohenthann (DE)
(74) Vertreter: Zedlitz, Peter, Dipl.-Inf.
(86) Internationale Anmeldenummer: DE9702730
(87) Internationale Veröffentlichungsnummer: WO9827594

(56) Entgegenhaltungen:
- EP-A- 0 673 070
- EP-A- 0 783 180
- US-A- 3 731 163
- US-A- 4 047 974
- US-A- 5 317 534
- US-A- 5 343 423

## Beschreibung

Für viele elektronische Systeme werden Speicher benötigt, in die Daten fest eingeschrieben sind. Derartige Speicher werden unter anderem als Festwertspeicher, Lesespeicher oder read only memory bezeichnet.

Für sehr große Datenmengen werden Compaktdiscs als Lesespeicher verwendet. Das sind Kunststoffscheiben mit einer Beschichtung aus Aluminium, in der zweierlei punktartige Vertiefungen angeordnet sind. In der Anordnung dieser Vertiefungen ist die Information digital gespeichert. Zum Lesen der auf einer Compaktdisc gespeicherten Daten wird die Scheibe in einem Lesegerät mechanisch rotiert und es werden die punktartigen Vertiefungen abgetastet. Auf einer Compaktdisc können 5 Gbits Informationen gespeichert werden.

Das Lesegerät weist bewegte Teile auf, die mechanischem Verschleiß unterworfen sind, die vergleichsweise viel Volumen benötigen und die nur einen langsamen Datenzugriff erlauben. Das Lesegerät ist darüber hinaus empfindlich gegen Erschütterungen und daher in mobilen Systemen nur begrenzt einsetzbar.

Festwertspeicher auf Halbleiterbasis erlauben dagegen einen wahlfreien Zugriff auf die gespeicherte Information. Darüber hinaus sind sie für mobile Systeme einsetzbar, da zum Lesen der Information kein mechanisches Laufwerk erforderlich ist. In diesen Festwertspeichern werden in der Regel MOS-Transistoren verwendet. Beim Lesevorgang wird bewertet, ob ein Strom durch den Transistor fließt oder nicht. Entsprechend wird die gespeicherte Information zugeordnet. Technisch wird die Speicherung der Information meist dadurch bewirkt, daß die MOS-Transistoren durch unterschiedliche Implantationen im Kanalgebiet unterschiedliche Einsatzspannungen aufweisen.

Die in Festwertspeichern auf Halbleiterbasis erzielbare Speicherdichte hängt vom Flächenbedarf pro Speicherzelle ab.

In DE-OS 195 10 042 ist eine Festwertspeicherzellenanordnung vorgeschlagen worden, die in Zeilen angeordnete MOS-Transistoren umfaßt. In jeder Zeile sind die MOS-Transistoren in Reihe verschaltet. Zur Erhöhung der Speicherdichte sind benachbarte Zeilen jeweils am Boden von streifenförmigen Längsgräben und zwischen benachbarten streifenförmigen Längsgräben an der Oberfläche des Substrats angeordnet. Miteinander verbundene Source/Drain-Gebiete sind als zusammenhängendes dotiertes Gebiet ausgebildet. Durch zeilenweises Ansteuern im Sinne einer "NAND"-Architektur werden die MOS-Transistoren ausgelesen.

Aus US 5 317 534 ist eine Festwertspeicherzellenanordnung bekannt, bei der zur Erzielung einer hohen Integrationsdichte streifenförmige Wortleitungen erzeugt werden, deren Abstand durch die Dicke einer Isolationsschicht - und damit unabhängig von einer verwendeten Photolithographie - bestimmt wird. Dazu werden zunächst Wortleitungen erzeugt, die mit einer dünnen Isolationsschicht bedeckt werden. Anschließend werden die Zwischenräume durch Auffüllen mit leitfähigem Material mit jeweils einer weiteren Wortleitung versehen. Damit ist sowohl eine NAND- als auch eine NOR-Anordnung möglich.

Eine weitere Speicherzellenanordnung ist aus US 5 343 423 bekannt. Sie umfaßt ein Halbleitersubstrat, in dem eine Vielzahl von elektrisch gegeneinander isolierten Wannen vorhanden sind. In den Wannen sind eine Vielzahl Speicherzellen in Zeilen und Spalten angeordnet, die Steuerelektroden aufweisen. Eine Vielzahl an Steuerleitungen ist mit den jeweiligen Steuerelektroden verbunden. An die Wannen werden steuerbare erste Spannungen angelegt. An die Steuerleitungen werden steuerbare zweite Spannungen angelegt. Die erste Spannung und die zweite Spannung werden so angelegt, daß eine Potentialdifferenz zwischen der Wanne und der Steuerelektrode einer Speicherzelle entsteht, die ausreichend zum Einschreiben oder Löschen von Daten in der Speicherzelle ist, wobei die Source-/Drain-Gebiete in der Speicherzelle floaten. Durch Ansteuerung der ersten und zweiten Spannungen werden die Speicherzellen selektiv in den Schreibzustand oder den Löschzustand gebracht.

Aus EP 0 673 070 A2 ist eine EEPROM-Anordnung mit NAND-Architektur bekannt. Dabei sind planare Transistoren alternierend am Boden von streifenförmigen Gräben und an der Substratoberfläche zwischen benachbarten streifenförmigen Gräben angeordnet. Dadurch wird eine hohe Packungsdichte erzielt.

Aus US-PS 4 047 974 ist eine nichtflüchtige Speicherzellenanordnung bekannt, in der als Speicherzellen MOS-Transistoren verwendet werden. Zwischen Source und Drain ist eine isolierende Schicht angeordnet, in die durch Implantation von Ionen Bereiche mit erhöhtem Ladungsträgereinfangquerschnitt eingebracht werden.

Die Programmierung der beschriebenen Speicherzellenanordnungen erfolgt bei der Herstellung. Für viele Anwendungen werden jedoch Speicher benötigt, in die Daten durch elektrische Programmierung eingeschrieben werden können. In elektrisch programmierbaren Speicherzellenanordnungen wird die Speicherung der Information meist dadurch bewirkt, daß zwischen dem Gate und dem Kanalgebiet der MOS-Transistoren ein floatendes Gate, das mit einer elektrischen Ladung beaufschlagt werden kann, oder als Gatedielektrikum eine Doppelschicht aus SiO₂ und Si₃N₄, an deren Grenzfläche elektrische Ladungsträger an Haftstellen festgehalten werden können, vorgesehen ist. Die Einsatzspannung des MOS-Transistors ist abhängig von der auf dem floatenden Gate bzw. den Haftstellen befindlichen Ladung. Diese Eigenschaft wird zur elektrischen Programmierung ausgenutzt (siehe zum Beispiel S. M. Sze, Semiconductor Devices, John Wiley, Seite 486 bis 490).

Der Erfindung liegt das Problem zugrunde, eine Speicherzellenanordnung anzugeben, die elektrisch programmierbar ist und die zur Speicherung von großen Datenmengen geeignet ist. Weiterhin soll ein Verfahren zu deren Herstellung angegeben werden.

Dieses Problem wird erfindungsgemäß gelöst durch eine Speicherzellenanordnung nach Anspruch 1 sowie durch ein Verfahren zu deren Herstellung nach Anspruch 8. Weitere Ausgestaltungen der Erfindung sind den übrigen Ansprüchen zu entnehmen.

Die Speicherzellenanordnung umfaßt in einem Halbleitersubstrat mehrere Speicherzellenzeilen. Benachbarte Speicherzellenzeilen sind gegeneinander isoliert.

Die Speicherzellenzeilen weisen jeweils ein erstes dotiertes Gebiet und ein zweites dotiertes Gebiet auf. Zwischen dem ersten dotierten Gebiet und dem zweiten dotierten Gebiet sind an einer Hauptfläche des Halbleitersubstrats ein Gatedielektrikum und mehrere nebeneinander angeordnete Gateelektroden angeordnet. Der Abstand zwischen benachbarten Gateelektroden ist dabei geringer als die Abmessungen der Gateelektroden parallel zu der Verbindungslinie zwischen dem ersten dotierten Gebiet und dem zweiten dotierten Gebiet. Das Gatedielektrikum enthält ein Material mit Ladungsträger-Haftstellen.

Haftstellen, englisch traps, haben die Eigenschaften Ladungsträger, speziell Elektronen, einzufangen. Zur elektrischen Programmierung werden die Gateelektroden so beschaltet, daß der zu speichernden Information entsprechende Ladungsträger in das Gatedielektrikum unterhalb der Gateelektrode gelangen und von den Haftstellen festgehalten werden. Da die Ladungsträger in den Haftstellen gefangen sind, ist die Information dauerhaft gespeichert. Die programmierte Speicherzellenanordnung stellt daher eine Festwert-Speicherzellenanordnung dar. Die Programmierung kann sowohl durch Fowler-Nordheim-Tunneln als auch durch Hot-Electron-Injection erfolgen. Durch Umkehr der Polaritäten beim Fowler-Nordheim-Tunneln können Ladungsträger aus den Haftstellen entfernt werden, so daß die Programmierung der Speicherzellenanordnung geändert wird.

Die Erfindung geht auf folgende Überlegungen zurück: Beim Ansteuern einer Zeile, in der in Reihe verschaltete MOS-Transistoren angeordnet sind, im Sinne einer "NAND"-Architektur werden die Gateelektroden der MOS-Transistoren so beschaltet, daß alle MOS-Transistoren bis auf den ausgewählten MOS-Transistor leiten, unabhängig von der Einsatzspannung des einzelnen nicht ausgewählten Transistors. Das wird dadurch bewirkt, daß an die Gateelektroden eine Spannung angelegt wird, die höher ist als die höchste auftretende Einsatzspannung. Die Gateelektrode des ausgewählten MOS-Transistors wird dagegen mit einer Spannung beaufschlagt, die zwischen den Einsatzspannungen der MOS-Transistoren liegt. Es wird bewertet, ob ein Strom über die in Reihe verschalteten MOS-Transistoren fließt oder nicht. Fließt ein Strom, so ist in dem ausgewählten MOS-Transistor die Information entsprechend der geringeren Einsatzspannung gespeichert. Fließt kein Strom, so ist die Information entsprechend der höheren Einsatzspannung gespeichert.

Die Erfindung macht sich die Erkenntnis zunutze, daß die meisten Source/Drain-Gebiete dieser MOS-Transistoren beim Auslesen lediglich als leitende Verbindung zwischen benachbarten leitenden Kanälen wirken. Daher werden in der erfindungsgemäßen Speicherzellenanordnung nur am Anfang und am Ende jeder Speicherzellenzeile ein dotiertes Gebiet entsprechend einem Source/Drain-Gebiet angeordnet, zwischen denen dicht nebeneinander angeordnete Gateelektroden durch entsprechende Beschaltung ein Raumladungsgebiet bis an das Kanalgebiet der ausgewählten Gateelektrode bewirken. Auf diese Weise wird in den Speicherzellenzeilen der Platzbedarf für zwischen zwei benachbarten Gateelektroden angeordnete Source/Drain-Gebiete eingespart. Das Streufeld zwischen benachbarten angesteuerten Gateelektroden bewirkt dabei, daß der Bereich unterhalb der Zwischenräume zwischen benachbarten Gateelektroden leitend gemacht wird. Vorzugsweise beträgt der Abstand zwischen benachbarten Gateelektroden 10 bis 100 nm.

In Anwendungen, in denen das Streufeld zwischen benachbarten angesteuerten Gateelektroden nicht ausreicht, um den Bereich unterhalb des Zwischenraums zwischen den benachbarten Gateelektroden leitend zu machen, liegt es im Rahmen der Erfindung, in diesem Bereich durch eine Gegendotierung die Dotierstoffverteilung an der Oberfläche zu modulieren. Dazu ist eine Dotierstoffkonzentration im Bereich von 10¹⁷ cm⁻³ ausreichend. Diese Dotierstoffkonzentration ist deutlich geringer als in dem ersten dotierten Gebiet und dem zweiten dotierten Gebiet, die wie Source-/Draingebiete eine Dotierstoffkonzentration im Bereich von 10²⁰ bis 10²¹ cm⁻³ aufweisen. Die Gegendotierung dient lediglich der Modulation benachbarter Raumladungszonen, mit üblichen Source/Drain-Gebieten ist sie nicht vergleichbar.

Zur Abspeicherung von Daten in digitaler Form werden unterhalb der Gateelektroden unterschiedliche Ladungsmengen in das Gatedielektrikum eingebracht, so daß in der Anordnung zwei unterschiedliche Einsatzspannungen auftreten. Soll die Speicherzellenanordnung für Mehrwertlogik eingesetzt werden, so wird das Gatedielektrikum durch entsprechende Spannungs- und Zeitbedingungen bei der Programmierung so mit unterschiedlichen Ladungsmengen beaufschlagt, daß je nach eingespeicherter Information mehr als zwei unterschiedliche Einsatzspannungen realisiert werden.

Das Gatedielektrikum ist gemäß einer Ausführungsform der Erfindung als Mehrfachschicht ausgebildet, in der mindestens eine Schicht vorgesehen ist, die im Vergleich mit mindestens einer weiteren Schicht in der Mehrfachschicht einen erhöhten Ladungsträgereinfangquerschnitt aufweist. Die Haftstellen sind an der Grenzfläche zwischen beiden Schichten lokalisiert. Vorzugsweise umfaßt die dielektrische Mehrfachschicht eine SiO₂-Schicht, eine Si₃N₄-Schicht und eine SiO₂-Schicht (sogenanntes ONO). Alternativ kann das Gatedielektrikum als Mehrfachschicht aus anderen Materialien, wobei die Schicht mit dem erhöhten Ladungsträgereinfangquerschnitt zum Beispiel aus Si₃N₄, Ta₂O₅, Al₂O₃ oder aus TiO₂ besteht und die benachbarte Schicht aus SiO₂, Si₃N₄ oder Al₂O₃ bestehen. Ferner kann die Mehrfachschicht mehr oder weniger als drei Schichten umfassen.

Alternativ kann das Gatedielektrikum eine dielektrische Schicht, zum Beispiel aus SiO₂, umfassen, in die Fremdatome, zum Beispiel W, Pt, Cr, Ni, Pd, oder Ir eingelagert sind. Die eingelagerten Fremdatome können durch Implantation, durch Zugabe bei einer Oxidation oder durch Diffusion eingebracht werden. Die eingelagerten Fremdatome bilden in diesem Fall die Haftstellen.

Benachbarte Speicherzellenzeilen können durch dazwischen angeordnete isolierende Gräben oder dazwischen angeordnete pn-Übergänge oder dadurch isoliert werden, daß in der Hauptfläche des Halbleitersubstrats parallele, streifenförmige Gräben vorgesehen sind und die Speicherzellenzeilen jeweils abwechselnd am Boden der Gräben und zwischen benachbarten Gräben an der Hauptfläche angeordnet sind.

Die Verwendung isolierender Gräben oder isolierender pn-Übergänge zwischen benachbarten Speicherzellenzeilen hat den Vorteil, daß die Speicherzellenanordnung planar ist, was die Zahl der erforderlichen Prozeßschritte und die Prozeßkomplexität reduziert.

Die Isolation der benachbarten Speicherzellenzeilen durch Anordnung am Boden und zwischen-benachbarten Gräben ermöglicht dagegen eine weitere Erhöhung der Speicherdichte, da die Isolation zwischen benachbarten Speicherzellenzeilen durch die Grabenwand realisiert wird.

In der Speicherzellenanordnung wirken die Speicherzellenzeilen als Bitleitungen. Die Gateelektroden werden mit quer zu den Speicherzellenzeilen verlaufenden Wortleitungen verbunden. Vorzugsweise werden die Gateelektroden streifenförmig aus leitfähigem Material ausgebildet, so daß die streifenförmigen Gateelektroden die Wortleitungen bilden.

Werden die Gateelektroden in einem engen Raster, zum Beispiel mit einem Abstand zwischen benachbarten Gateelektroden von einer minimalen Strukturgröße F, gebildet, so liegt es im Rahmen der Erfindung, zur leichteren Kontaktierung der Gateelektroden die Gateelektroden mit Aufweitungen zu versehen, an denen Kontakte angebracht werden. Die Aufweitungen benachbarter Gateelektroden sind dabei gegeneinander versetzt angeordnet. Vorzugsweise werden die Gateelektroden als streifenförmige Strukturen gebildet, wobei in den Längsseiten der Gateelektroden im Bereich von Aufweitungen Stufen vorgesehen sind. Durch eine versetzte Anordnung dieser Stufen entlang benachbarter Gateelektroden wird der zusätzliche Platzbedarf für die Aufweitungen auf die Breite einer Aufweitung begrenzt.

Zur Ansteuerung der Bitleitungen liegt es im Rahmen der Erfindung, mehrere benachbarte Bitleitungen in einem Knoten zusammenzuführen und zwischen dem Knoten und dem dotierten Gebiet, das die Speicherzellenzeile beendet, einen Auswahlschalter oder einen Dekoder vorzusehen. Dazu werden zwischen dem Knoten und dem dotierten Gebiet jeweils mindestens ein MOS-Transistor gebildet, der über eine Auswahlelektrode ansteuerbar ist. Die Auswahlelektrode wird dabei als Auswahlleitung, die quer zu den Bitleitungen verläuft, realisiert. An Kreuzungspunkten der Auswahlleitung mit einer Bitleitung, die an dem Kreuzungspunkt keinen Auswahltransistor aufweisen soll, wird durch eine Kanalimplantation unterhalb der entsprechenden Auswahlleitung eine solche Dotierung erzeugt, daß der unterhalb der Auswahlleitung gebildete, parasitäre MOS-Transistor eine so niedrige Einsatzspannung aufweist, daß er leitet, unabhängig davon, ob an die Auswahlleitung eine Spannung angelegt wird oder nicht.

Wird zwischen dem Knoten und den dotierten Gebieten ein Auswahlschalter gebildet, so werden so viele Auswahlleitungen gebildet wie Bitleitungen zusammengefaßt werden. Die Auswahltransistoren werden entlang der Diagonale der Kreuzungspunkte zwischen den Auswahlleitungen und den Bitleitungen erzeugt.

Wird ein Dekoder zwischen dem Knoten und den dotierten Gebieten gebildet, so werden, wenn 2n Bitleitungen im Knoten zusammengeführt werden, 2 ⁿ Auswahlleitungen gebildet. Je zwei benachbarte Auswahlleitungen sind dabei bezüglich der Anordnung der Auswahltransistoren zueinander komplementär. In jedem n-ten Auswahlleitungspaar sind dabei jeweils an 2ⁿ⁻¹ Kreuzungspunkten der Auswahlleitungen mit den Bitleitungen nebeneinander MOS-Transistoren angeordnet bzw. keine MOS-Transistoren angeordnet.

Zur Herstellung der Speicherzellenanordnung werden in einem Halbleitersubstrat, vorzugsweise einer monokristallinen Siliziumscheibe oder der Siliziumschicht eines SOI-Substrats, mehrere Speicherzellenzeilen erzeugt, die gegeneinander isoliert werden. Für jede Speicherzellenzeile werden in dem Halbleitersubstrat ein erstes dotiertes Gebiet und ein zweites dotiertes Gebiet gebildet.

Es wird eine dielektrische Schicht, die ein Material mit Ladungsträgerhaftstellen enthält, gebildet. Darauf wird eine erste Elektrodenschicht erzeugt und zur Bildung erster Gateelektroden strukturiert. An den Flanken der ersten Gateelektroden werden Spacer gebildet. Es wird eine zweite dielektrische Schicht gebildet, die ein Material mit Ladungsträgerhaftstellen enthält. Zur Bildung zweiter Gateelektroden wird eine zweite Elektrodenschicht mit im wesentlichen konformer Kantenbedeckung erzeugt und strukturiert. Die ersten Gateelektroden und die zweiten Gateelektroden sind jeweils nebeneinander angeordnet, wobei der Abstand zwischen benachbarten Gateelektroden geringer ist als die Abmessungen der Gateelektroden parallel zu der Verbindungslinie zwischen dem ersten dotierten Gebiet und dem zweiten dotierten Gebiet.

Es liegt im Rahmen der Erfindung, die Spacer zwischen den ersten Gatelektroden und den zweiten Gateelektroden selektiv zu den ersten Gateelektroden und den zweiten Gateelektroden zu entfernen und selbstjustiert eine Gegendotierung vorzunehmen, durch die die Dotierung des Halbleitersubstrats im Bereich zwischen den ersten Gateelektroden und den zweiten Gateelektroden moduliert wird. Die Gegendotierung erfolgt mit einer Dotierstoffkonzentration im Bereich zwischen unter 5 x 10¹⁷ cm⁻³. Vorzugsweise wird die Gegendotierung auf einen etwas höheren Wert, zum Beispiel das Zwei- bis Dreifache der Dotierstoffkonzentration eingestellt, die als Kanaldotierung eines MOS-Transistors in der verwendeten Technologie verwendet wird.

Zur Isolation zwischen benachbarten Speicherzellenzeilen liegt es im Rahmen der Erfindung, zwischen den benachbarten Speicherzellenzeilen jeweils mit Hilfe einer Shallow Trench Isolation (STI)-Technologie streifenförmige Isolationsgräben zu bilden. Werden die Gateelektroden mit einem Abstand entsprechend einer minimalen Strukturgröße F gebildet und weisen die Speicherzellenzeilen sowie die Isolationsgräben jeweils eine Breite von ebenfalls F auf, so ergibt sich in diesem Fall unter Vernachlässigung des Flächenbedarfs der ersten dotierten Gebiete und der zweiten dotierten Gebiete ein Flächenbedarf pro Speicherzelle von 2F².

Es liegt im Rahmen der Erfindung, benachbarte Speicherzellenzeilen dadurch zu isolieren, daß sie jeweils abwechselnd am Boden von streifenförmigen, im wesentlichen parallelen Gräben und zwischen den Gräben an der Hauptfläche des Halbleitersubstrats gebildet werden. In diesem Fall wirkt die Seitenwand der Gräben als Isolation zwischen den benachbarten Speicherzellenzeilen. Werden in diesem Fall die Gateelektroden mit einem Abstand zwischen ihren Mitten von einer minimalen Strukturgröße F und die Gräben ebenfalls mit einem Abstand ihrer Mitten von einer Strukturgröße F gebildet, so ergibt sich, unter Vernachlässigung des Platzbedarfs für die ersten dotierten Gebiete und die zweiten dotierten Gebiete ein Platzbedarf pro Speicherzelle von 1 F².

Im folgenden wird die Erfindung anhand von Ausführungsbeispielen, die in den Figuren dargestellt sind, näher erläutert.
- Figur 1: zeigt eine Aufsicht auf eine Speicherzellenanordnung, in der benachbarte Speicherzellenzeilen durch isolierende Gräben gegeneinander isoliert sind.
- Figur 2: zeigt einen in Figur 1 mit A-A bezeichneten Schnitt durch ein Halbleitersubstrat nach einer Kanalimplantation zur Einstellung der Einsatzspannung eines Auswahltransistors.
- Figur 3: zeigt den Schnitt durch das Halbleitersubstrat nach Bildung einer ersten dielektrischen Schicht, erster Gateelektroden und Auswahlleitungen.
- Figur 4: zeigt den Schnitt durch das Substrat nach Strukturierung der ersten dielektrischen Schicht und nach Bildung von Spacern an den Flanken der ersten Gateelektroden.
- Figur 5: zeigt den Schnitt durch das Halbleitersubstrat nach Bildung einer zweiten-dielektrischen Schicht und einer zweiten Elektrodenschicht.
- Figur 6: zeigt das Substrat nach Bildung zweiter Gatelektroden durch Strukturierung der zweiten Elektrodenschicht.
- Figur 7: zeigt den Schnitt durch das Halbleitersubstrat nach einer Implantation zur Bildung von ersten dotierten Gebieten, zweiten dotierten Gebieten und von Source/Drain-Gebieten.
- Figur 8: zeigt eine Aufsicht auf die Speicherzellenanordnung nach Bildung von Kontakten zu den ersten Gateelektroden und den zweiten Gateelektroden.
- Figur 9: zeigt eine Aufsicht auf eine Speicherzellenanordnung, in der benachbarte Speicherzellenzeilen abwechselnd am Boden von Gräben und zwischen benachbarten Gräben angeordnet sind und so durch die Seitenwände der Gräben gegeneinander isoliert sind.
- Figur 10: ) zeigt den in Figur 9 mit A-A bezeichneten Schnitt durch das Halbleitersubstrat nach einer Implantation zur Programmierung der Transistoren des Dekoders, die zwischen benachbarten Gräben angeordnet sind.
- Figur 11: zeigt den in Figur 9 mit C-C bezeichneten Schnitt nach der Ätzung streifenförmiger Gräben.
- Figur 12: zeigt den in Figur 9 mit B-B bezeichneten Schnitt nach einer Implantation zur Programmierung der Transistoren des Dekoders, die am Boden der streifenförmigen Gräben angeordnet sind.
- Figur 13: zeigt den Schnitt A-A nach Bildung erster Wortleitungen.
- Figur 14: zeigt den Schnitt C-C nach der Bildung der ersten Wortleitungen.
- Figur 15: zeigt den Schnitt B-B nach der Bildung der ersten Wortleitungen.
- Figur 16: zeigt den Schnitt A-A nach Bildung von Spacern an den Flanken der ersten Wortleitungen.
- Figur 17: zeigt den Schnitt B-B nach Bildung der Spacer an den Flanken der ersten Wortleitungen.
- Figur 18 und Figur 19: zeigen die Schnitte A-A bzw. B-B nach Bildung einer zweiten dielektrischen Schicht und einer zweiten Elektrodenschicht.
- Figur 20: zeigt den Schnitt A-A nach Bildung zweiter Wortleitungen durch Strukturierung der zweiten Elektrodenschicht.
- Figur 21: zeigt den Schnitt B-B nach Bildung der zweiten Wortleitungen.
- Figur 22: zeigt den Schnitt B-B nach Entfernung von Ätzresten der zweiten Elektrodenschicht am Grabenboden.
- Figur 23: zeigt den Schnitt A-A nach Bildung der ersten und zweiten dotierten Gebiete und von Source/Drain-Sebieten.
- Figur 24: zeigt den Schnitt B-B nach Bildung der ersten dotierten Gebiete, zweiten dotierten Gebiete und der Source/Drain-Gebiete.

Die Darstellungen in den Figuren sind nicht maßstäblich.

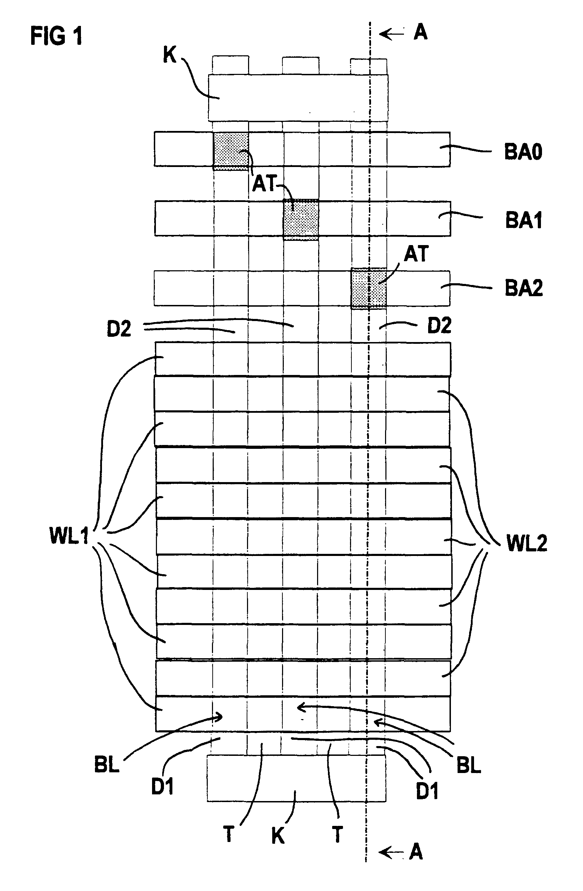

Eine Speicherzellenanordnung umfaßt erste Wortleitungen WL1 und zweite Wortleitungen WL2, die jeweils alternierend zueinander angeordnet sind (siehe Figur 1). Quer dazu verlaufen Bitleitungen BL, die jeweils durch Speicherzellenzeilen mit einem ersten dotierten Gebiet D1, einem zweiten dotierten Gebiet D2 und dazwischen angeordneten Gatedielektrikum und Gateelektroden, die jeweils durch den entsprechenden Teil der ersten Wortleitungen WL1 und der zweiten Wortleitungen WL2 gebildet werden, aufweisen. Benachbarte Bitleitungen BL werden durch isolierende Gräben T gegeneinander isoliert.

Der Abstand der Mitten benachbarter Bitleitungen beträgt zum Beispiel 2F, wobei F die minimal herstellbare Strukturgröße ist, zum Beispiel 0,5 µm. Der Abstand der Mitten zwischen benachbarten ersten Wortleitungen WL1 und zweiten Wortleitungen WL2 beträgt F, zum Beispiel 0,5 µm. Definiert man als Speicherzelle den Kreuzungsbereich zwischen einer der Wortleitungen WL1, WL2 und einer der Bitleitungen BL, so ergibt sich ein Platzbedarf pro Speicherzelle von 2F², zum Beispiel 0,5 µm².

Der Bereich, in dem sich die Wortleitungen WL1, WL2 mit den Bitleitungen BL kreuzen, entspricht dem Speicherzellenfeld der Speicherzellenanordnung. Außerhalb dieses Speicherzellenfeldes ist ein Auswahlschalter vorgesehen, der Bitauswahlleitungen BA aufweist, die die Bitleitungen BL kreuzen. Mehrere benachbarte Bitleitungen BL, zum Beispiel drei, sind durch eine Metallisierung M zu einem Knoten K zusammengefaßt. Es sind zwischen dem Knoten K und den zweiten dotierten Gebieten D2 so viele Bitauswahlleitungen BA angeordnet, wie Bitleitungen BL in dem Knoten K zusammengeführt werden, das heißt zum Beispiel drei.

Am Kreuzungspunkt der Bitleitungen BL mit pro Bitleitung BL einer der Bitauswahlleitungen BA ist jeweils ein Auswahltransistor angeordnet, der über die entsprechende Bitauswahlleitung BA angesteuert werden kann. An den Kreuzungspunkten der Bitleitungen BL mit den anderen der Bitauswahlleitungen BA wird unterhalb der Bitauswahlleitung BA eine solche Dotierung eingestellt, daß der an diesen Kreuzungspunkten gebildete parasitäre MOS-Transistor eine solche Einsatzspannung aufweist, daß er unabhängig von den an den Bitauswahlleitungen anliegenden Pegeln leitet. Vorzugsweise weist er dazu eine negative Einsatzspannung auf. Der Abstand zwischen den Mitten benachbarter Bitauswahlleitungen BA beträgt zum Beispiel 2F.

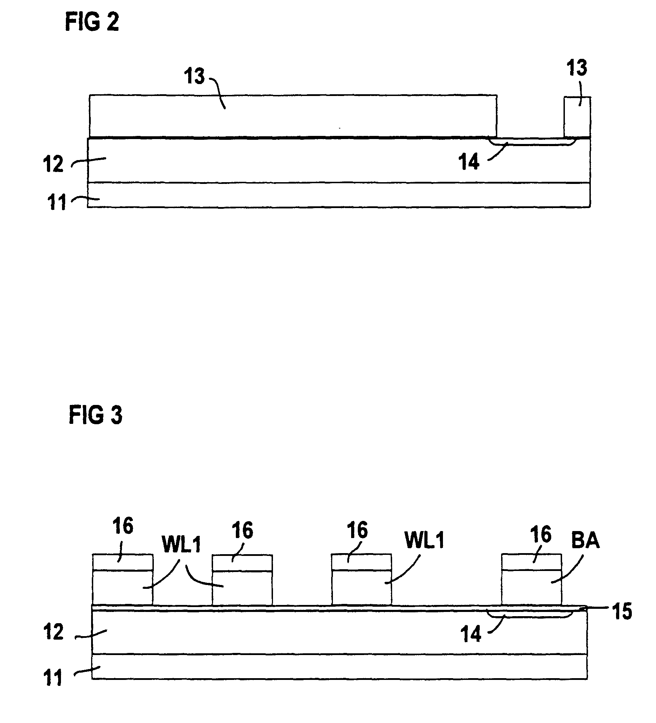

Zur Herstellung der Speicherzellenanordnung wird in einem Substrat 1 aus zum Beispiel p-dotiertem monokristallinem Silizium mit einer Grunddotierstoffkonzentration von 2 x 10¹⁵ cm⁻³ eine p-dotierte Wanne 2 mit einer Dotierstoffkonzentration von zum Beispiel 1 x 10¹⁷ cm⁻³ durch Implantation gebildet (siehe Figur 2). Die Tiefe der p-dotierten Wanne 12 beträgt zum Beispiel 1 µm.

Nach dem ein Streuoxid in einer Schichtdicke von 5 nm aufgebracht ist, erfolgt eine Einsatzspannungsimplantation zum Beispiel mit Bor mit einer Dosis von 3 x 10¹² cm⁻² und einer Energie von 25 keV (nicht dargestellt). Anschließend wird eine Programmiermaske 13 zum Beispiel als Photolack durch photolithographische Prozeßschritte gebildet. Es wird eine Implantation mit n-dotierenden Ionen, zum Beispiel As mit einer Dosis von 1 x 10¹⁴ cm⁻² und einer Energie von 40 keV durchgeführt, bei der der Auswahlschalter programmiert wird. Dabei werden Kanaldotierungen 14 erzeugt an denjenigen Kreuzungspunkten der Bitauswahlleitungen BA mit den Bitleitungen BL, an denen keine Auswahltransistoren AT gebildet werden.

Nach Entfernen der Programmiermaske 13 und des Streuoxids wird ganzflächig eine erste dielektrische Schicht 15 gebildet (siehe Figur 3). Die erste dielektrische Schicht 15 wird als Dreifachschicht aus einer ersten Siliziumoxidschicht mit einer Dicke von 3 nm, einer Siliziumnitridschicht mit einer Dicke von 8 nm und einer zweiten Siliziumoxidschicht mit einer Dicke von 4 nm gebildet.

Durch Abscheiden einer ersten Elektrodenschicht und einer ersten SiO₂-Schicht und anschließendes Strukturieren durch zum Beispiel anisotropes Ätzen werden die ersten Wortleitungen WL1 und die Bitauswahlleitungen BA gebildet, die jeweils von einer ersten SiO₂-Struktur 16 bedeckt sind (siehe Figur 3). Die erste Elektrodenschicht wird zum Beispiel aus dotiertem Polysilizium in einer Schichtdicke von zum Beispiel 0,4 µm durch in situ dotierte Abscheidung oder undotierte Abscheidung und anschließende Dotierung der Implantation oder Diffusion gebildet. Die erste Elektrodenschicht kann auch aus Metallsilizid und/oder Metall gebildet werden.

Die erste SiO₂-Schicht wird zum Beispiel in einem TEOS-Verfahren in einer Schichtdicke von 200 nm gebildet. Die Strukturierung erfolgt zum Beispiel durch anisotropes Ätzen mit CHF₃.

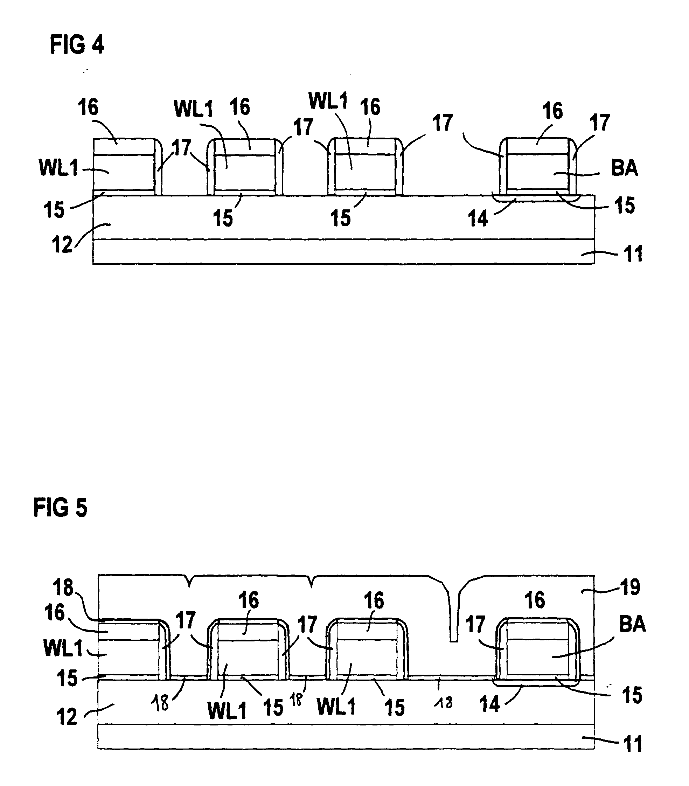

Durch Trockenätzen mit CHF₃ wird anschließend die erste dielektrische Schicht 15 strukturiert. Durch Abscheiden einer weiteren SiO₂-Schicht zum Beispiel in einem TEOS-Verfahren oder aus Phosphorsilikatglas werden an den Flanken der ersten Wortleitungen WL1 und der Bitauswahlleitungen BA Spacer 17 gebildet. Die Spacer 17 weisen eine Breite von etwa 50 nm auf. Dazu ist eine Dicke der weiteren SiO₂-Schicht von 50 nm erforderlich (siehe Figur 4). Die Spacerätzung erfolgt mit zum Beispiel CHF₃.

Zur Verbesserung der Kristallqualität wird anschließend eine Opferschicht aus Siliziumoxid, sogenanntes sacrificial oxid, aufgewachsen und mit Flußsäure geätzt (nicht dargestellt). Anschließend wird eine zweite dielektrische Schicht 18 ganzflächig erzeugt (siehe Figur 5). Die zweite dielektrische Schicht 18 wird wie die erste dielektrische Schicht 15 als Dreifachschicht aus Siliziumoxid, Siliziumnitrid und Siliziumoxid gebildet. Die Schichtdicken entsprechen denen in der ersten dielektrischen Schicht 15.

Anschließend wird ganzflächig eine zweite Elektrodenschicht 19 aus zum Beispiel n-dotiertem Polysilizium, Metallsilizid und/oder Metall gebildet. Die zweite Elektrodenschicht 19 wird in einer Schichtdicke von 0,4 µm gebildet. Sie füllt die Abstände zwischen benachbarten Wortleitungen WL1 vollständig auf.

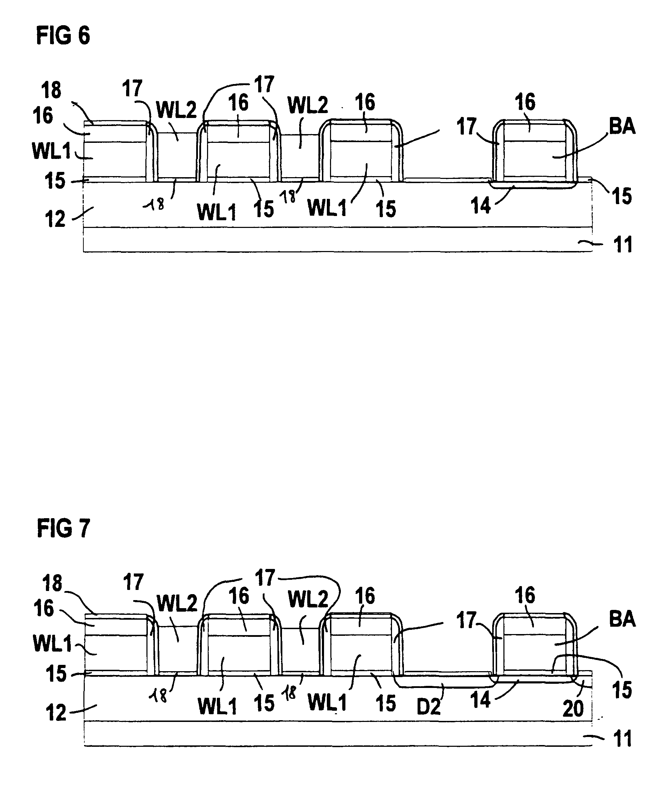

Durch Strukturierung der zweiten Elektrodenschicht 19 werden anschließend die zweiten Wortleitungen WL2 gebildet. Die Strukturierung der zweiten Elektrodenschicht 19 erfolgt durch isotropes Rückätzen zum Beispiel mit CF₄/O₂. Dabei wirkt die Oberfläche der zweiten dielektrischen Schicht 18 als Ätzstop. Die Ätzung wird solange fortgesetzt, bis der Anteil der zweiten Elektrodenschicht 19, der zwischen den Bitauswahlleitungen BA und der den Bitauswahlleitungen BA benachbarten ersten Wortleitung WL1 angeordnet ist, vollständig entfernt ist. Dabei wird ausgenutzt, daß der Abstand zwischen den Bitauswahlleitungen BA und der ihnen benachbarten ersten Wortleitung WL1 größer ist als der Abstand zwischen benachbarten Wortleitungen WL1 (siehe Figur 6).

In Anwendungen, in denen eine Modulation der Dotierung an der Oberfläche der p-dotierten Wanne 12 erforderlich ist, wird anschließend der obere Bereich der zweiten dielektrischen Schicht 18 zum Beispiel mit Flußsäure entfernt, so daß die Oberfläche der Spacer 17 teilweise freigelegt wird. Anschließend werden die Spacer 17 selektiv zu dotiertem Polysilizium entfernt. Es wird eine Implantation mit n-dotierenden Ionen, zum Beispiel mit As mit einer Dosis von 1 x 10¹² bis 1 x 10¹³ cm⁻² und einer Energie von 20 keV durchgeführt.

Alternativ zur Implantation kann auch eine Diffusion erfolgen. Dazu ist es zweckmäßig, die durch das Entfernen der Spacer 17 entstandenen Lücken mit Phosphorsilikatglas, das zum Beispiel als Zwischenoxid verwendet wird, aufzufüllen und den Dotierstoff durch Ausdiffusion in die p-dotierte Wanne 12 einzubringen. Die Dotierung kann auch durch Ausdiffusion aus den Spacern 17 erfolgen, falls diese aus Phosphorsilikatglas gebildet sind.

Anschließend wird eine Implantation zum Beispiel mit As mit einer Dotierstoffkonzentration von 5 x 10¹⁵ cm⁻² und einer Energie von 80 keV durchgeführt, bei der die ersten dotierten Gebiete D1, die zweiten dotierten Gebiete D2 und Source/Drain-Gebiete 20 für die Auswahltransistoren AT gebildet werden (siehe Figur 7 und Figur 1).

Es liegt im Rahmen der Erfindung, die Implantation zweistufig im Sinne einer LDD- und HDD-Implantation durchzuführen.

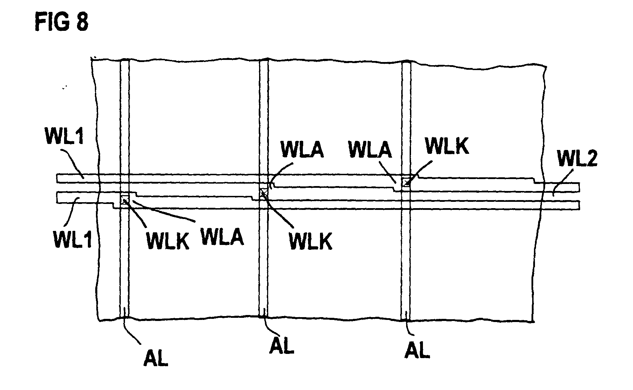

Zur besseren Kontaktierbarkeit der ersten Wortleitungen WL1 und der zweiten Wortleitungen WL2 werden diese so strukturiert, daß sie Wortleitungsaufweitung WLA aufweisen, an denen Wortleitungskontakte WLK zu quer dazu verlaufenden Aluminiumbahnen AL gebildet werden (siehe Figur 8). Dazu werden die Wortleitungen WL1, WL2 so gebildet, daß sie im Bereich des Wortleitungskontaktes WLK einseitig verbreitert werden. Die Wortleitungsaufweitung WLA entsteht dadurch, daß diese einseitigen Verbreiterungen jeweils auf gegenüberliegenden Seiten der Wortleitung WL1, WL2 angeordnet ist. Vor und hinter der Wortleitungsaufweitung WLA ist die Breite der Wortleitung WL1, WL2 geringer als im Bereich der Wortleitungsaufweitung WLA. Ferner ist die Mitte der Wortleitung WL1, WL2 vor und hinter der Wortleitungsaufweitung WLA gegeneinander versetzt.

Die Wortleitungsaufweitungen WLA von benachbarten Wortleitungen WL1, WL2 sind gegeneinander versetzt angeordnet. Die Breite der Wortleitungen WL1, WL2 beträgt außerhalb der Wortleitungsaufweitungen WLA etwa die Hälfte des Wertes im Bereich der Wortleitungsaufweitung WLA. Auf diese Weise wird eine sichere Öffnung der Kontaktlöcher zur Bildung der Wortleitungskontakte WLK gewährleistet, ohne den Platzbedarf der Wortleitungen allzusehr zu vergrößern. Über das gesamte Zellenfeld bewirken die Wortleit-ungsaufweitungen WLA einen zusätzlichen Platzbedarf in Richtung der Breite der Wortleitungen WL1, WL2 von etwa einer Wortleitung je Segment. Ein Segment umfaßt zum Beispiel 32 bis 128 Wortleitungen.

Die Speicherzellenanordnung wird durch Abscheidung eines Zwischenoxids, Kontaktlochätzungen und Aufbringen und Strukturieren einer Metallschicht fertiggestellt. Diese bekannten Prozeßschritte sind nicht dargestellt.

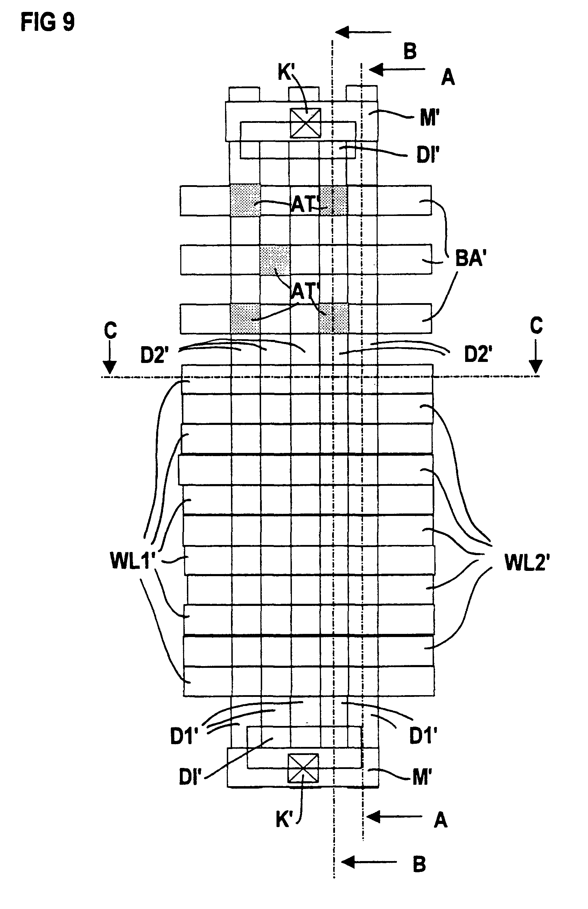

Gemäß einer weiteren Ausführungsform umfaßt eine Speicherzellenanordnung erste Wortleitungen WL1' und zweite Wortleitungen WL2', die alternierend angeordnet sind (siehe Figur 9). Der Abstand zwischen den Wortleitungen WL1' und den benachbarten zweiten Wortleitungen WL2' ist dabei geringer als die Breite der Wortleitungen WL1', WL2'. Quer zu den Wortleitungen WL1', WL2' verlaufen Bitleitungen BL', die jeweils ein erstes dotiertes Gebiet D1', ein zweites dotiertes Gebiet D2', ein Gatedielektrikum und die dazwischen angeordneten, als Gateelektroden wirkenden Wortleitungen WL1', WL2' umfassen. Der Bereich, in dem sich die Wortleitungen WL1', WL2' und die Bitleitungen BL' schneiden, entspricht dem Zellenfeld der Speicherzellenanordnung. Die Bitleitungen BL' sind alternierend am Boden von Gräben und zwischen benachbarten Gräben angeordnet. Die Bitleitungen BL' sind gegeneinander durch die Seitenwände der Gräben isoliert. Der Abstand der Mitten benachbarter erster Wortleitungen WL1' und zweiter Wortleitungen WL2' beträgt zum Beispiel eine minimale Strukturgröße F. Der Abstand zwischen den Mitten benachbarter Bitleitungen BL' beträgt ebenfalls eine minimale Strukturgröße F. Damit beträgt der Platzbedarf pro Speicherzelle, die als Kreuzung einer der Wortleitungen WL1', WL2' mit einer der Bitleitungen BL' definiert wird, 1 F².

Außerhalb des Zellenfeldes ist ein Dekoder angeordnet, der quer zu den Bitleitungen BL' verlaufende Bitauswahlleitungen BA' umfaßt. Über die Bitauswahlleitungen BA' sind Auswahltransistoren AT des Dekoders ansteuerbar. An Kreuzungspunkten der Bitauswahlleitungen BA' mit den Bitleitungen BL', an denen keine Auswahltransistoren AT' angeordnet sind, ist unterhalb der Bitauswahlleitungen BA' eine Kanaldotierung vorgesehen, durch die der an diesem Kreuzungspunkt entstehende parasitäre MOS-Transistor eine solche Einsatzspannung aufweist, daß er, unabhängig von dem an der entsprechenden Bitauswahlleitung BA' anliegenden Pegel, leitet. Vorzugsweise ist diese Einsatzspannung negativ.

Benachbarte Bitleitungen BL', zum Beispiel 5, sind über einen Diffusionskontakt DI' und eine Metallisierung M' miteinander und mit einem Knoten K' verbunden.

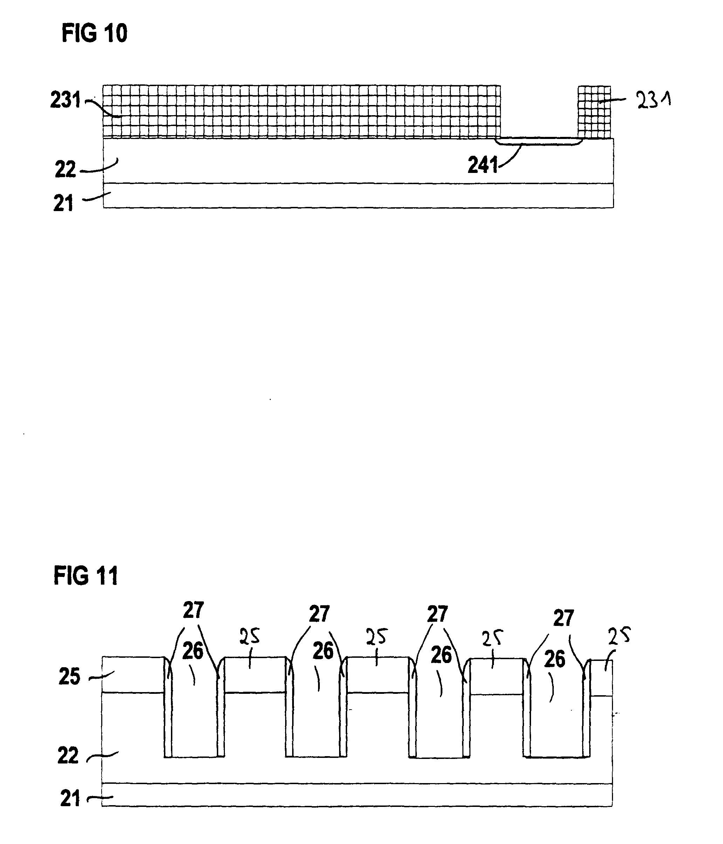

In einem Substrat 21, zum Beispiel in einer p-dotierten monokristallinen Siliziumscheibe mit einer Dotierstoffkonzentration von 2 x 10¹⁵ cm⁻³ oder in der Siliziumschicht eines SOI-Substrates, wird zum Beispiel durch Implantation mit Bor eine p-dotierte Wanne 22 gebildet. Die p-dotierte Wanne 22 weist eine Dotierstoffkonzentration von zum Beispiel 1 x 10¹⁷ cm⁻³ und eine Tiefe von zum Beispiel 1 µm auf (siehe Figur 10).

Anschließend wird ein Streuoxid in einer Dicke von zum Beispiel 5 nm aufgebracht (nicht dargestellt). Zur Einstellung der Einsatzspannung wird ganzflächig eine Borimplantation zum Beispiel mit einer Dosis von 3 x 10¹² cm⁻² und einer Energie von 25 keV durchgeführt.

Anschließend wird mit Hilfe photolithographischer Prozeßschritte eine erste Programmiermaske 231, zum Beispiel aus Photolack, gebildet. Es folgt eine Implantation mit n-dotierenden Ionen zur Programmierung der Transistoren des Dekoders, die zwischen benachbarten Gräben angeordnet sind. Die Implantation erfolgt zum Beispiel mit As bei einer Energie von 40 keV und einer Dosis von 1 x 10¹⁴ cm⁻². Dabei werden Kanaldotierungen 241 gebildet.

Nach Entfernen der ersten Programmiermaske 231 wird durch Abscheidung einer TEOS-SiO₂-Schicht und anschließende Strukturierung eine TEOS-Hartmaske 25 in einer Dicke von zum Beispiel 300 nm erzeugt (siehe Figur 11, in der der in Figur 9 mit C-C bezeichnete Schnitt durch das Halbleitersubstrat dargestellt ist). Durch anisotropes Ätzen zum Beispiel mit HBr unter Verwendung der TEOS-Hartmaske 25 als Ätzmaske werden in das Substrat streifenförmige Gräben 26 geätzt. Die Gräben 26 weisen eine Tiefe von 0,6 µm auf (siehe Figur 11). Anschließend werden an den Seitenwänden der Gräben 26 SiO₂-Spacer 27 durch Abscheidung einer SiO₂-Schicht in einer Dicke von 50 nm und Rückätzen mit CHF₃ gebildet.

Nachfolgend wird ganzflächig eine Implantation zur Einstellung der Einsatzspannung von am Boden der Gräben 26 herzustellenden MOS-Transistoren durchgeführt. Die Implantation wird zum Beispiel mit Bor mit einer Energie von 25 keV und einer Dosis von 3 x 10¹² cm⁻² durchgeführt.

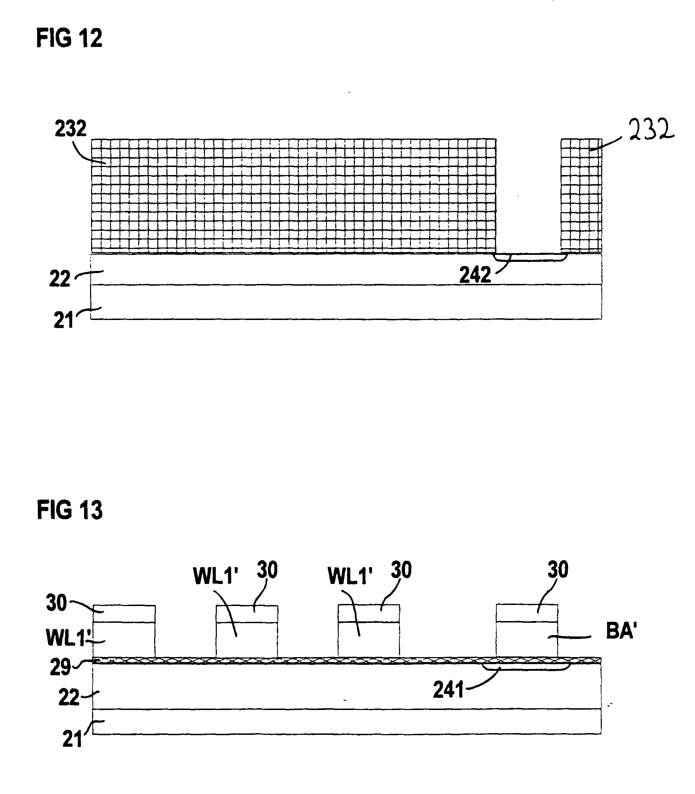

Nachfolgend wird eine zweite Programmiermaske 232 zum Beispiel aus Photolack mit Hilfe photolithographischer Prozeßschritte gebildet. Durch Implantation mit n-dotierenden Ionen, zum Beispiel mit As mit einer Energie von 40 keV und einer Dosis von 1 x 10¹⁴ cm⁻² werden Kanaldotierungen 242 gebildet. Dadurch werden MOS-Transistoren des Dekoders, die am Boden der Gräben 26 angeordnet sind, programmiert (siehe Figur 12, die den in Figur 9 mit B-B bezeichneten Schnitt parallel zu einem der Gräben 26 am Boden des Grabens 26 darstellt). Die zweite Programmiermaske 232 bedeckt dabei das Zellenfeld vollständig.

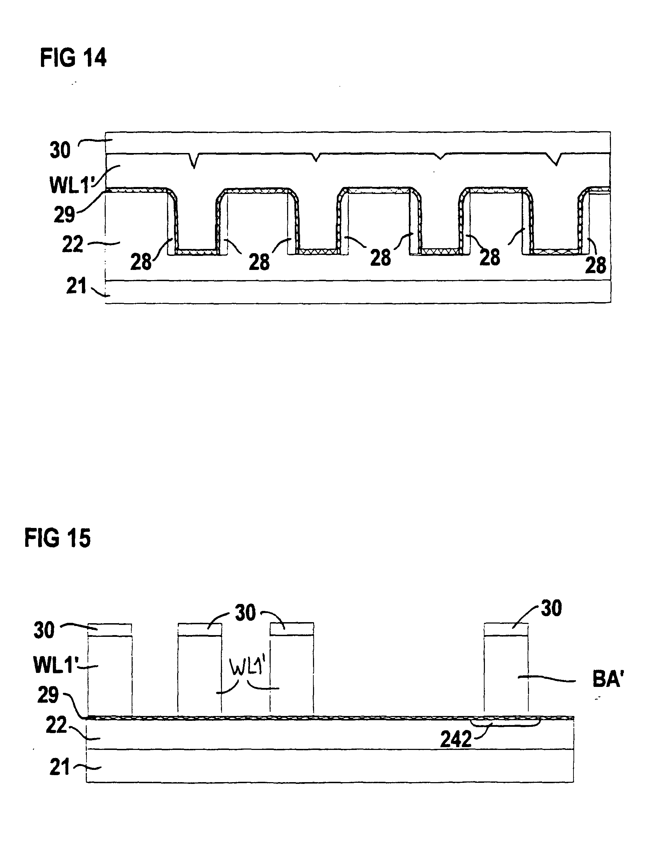

Nach Entfernen der zweiten Programmiermaske 232 und der Hartmaske 25 sowie der SiO₂-Spacer 27 durch naßchemisches Ätzen zum Beispiel mit Flußsäure werden an den Seitenwänden der Gräben weitere SiO₂-Spacer 28 gebildet. Dazu wird eine TEOS-SiO₂-Schicht in einer Schichtdicke von 80 nm abgeschieden und mit CHF₃ geätzt (siehe Figur 14, in der der Schnitt C-C dargestellt ist).

Es wird ganzflächig eine erste dielektrische Schicht 29 gebildet. Die erste dielektrische Schicht 29 wird als Dreifachschicht gebildet, die eine erste SiO₂-Schicht mit einer Dicke von 3 nm, eine Si₃N₄-Schicht mit einer Dicke von 8 nm und eine zweite SiO₂-Schicht mit einer Dicke von 4 nm umfaßt (siehe Figur 13, die den Schnitt A-A darstellt, Figur 14, die den Schnitt C-C darstellt und Figur 15, die den Schnitt B-B darstellt).

Anschließend wird zur Bildung der ersten Wortleitungen WL1' und einer diese bedeckenden Siliziumoxidschicht 30 eine erste Elektrodenschicht und eine TEOS- SiO₂-Schicht abgeschieden. Die erste Elektrodenschicht wird zum Beispiel durch in situ dotierte Abscheidung von Polysilizium oder durch undotierte Abscheidung von Polysilizium und anschließende Dotierung durch Implantation oder Diffusion in einer Schichtdicke von 0,4 µm gebildet. Die TEOS- SiO₂-Schicht 30 wird in einer Schichtdicke von 200 nm gebildet. Die Strukturierung erfolgt zum Beispiel mit CHF₃. Durch Strukturierung der ersten Elektrodenschicht durch anisotropes Ätzen zum Beispiel mit HBr werden die ersten Wortleitungen WL1' gebildet. Bei der Bildung der ersten Wortleitungen WL1' werden gleichzeitig die Bitauswahlleitungen BA' erzeugt.

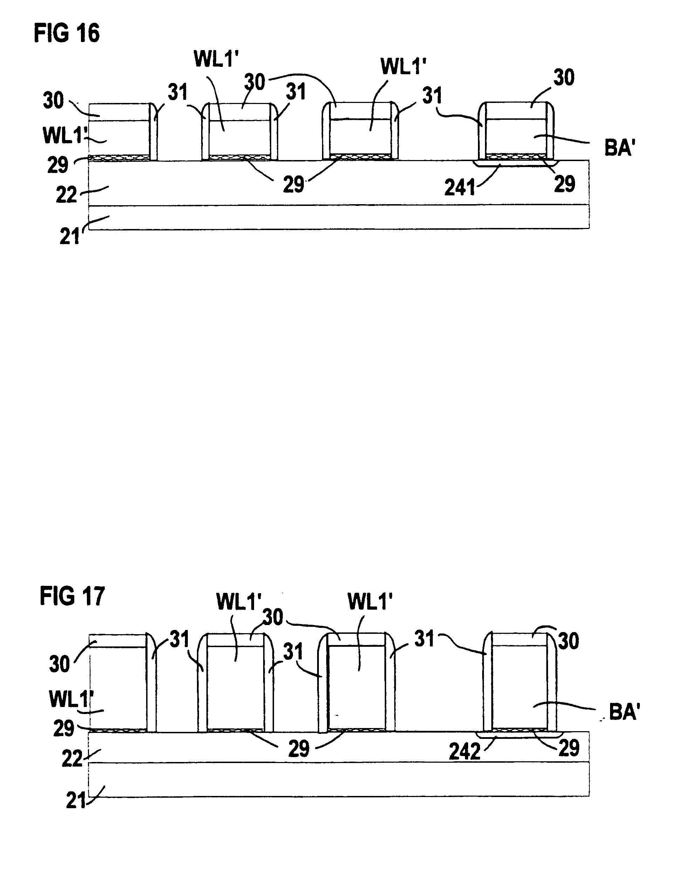

Mit Hilfe von CHF₃ wird anschließend die erste dielektrische Schicht 29 strukturiert (siehe Figur 16, in der der Schnitt A-A dargestellt ist, und Figur 17, in der der Schnitt B-B darstellt ist). Durch Abscheiden einer isolierenden Schicht, zum Beispiel aus TEOS-SiO₂ oder aus Phosphorsilikatglas, und anisotropes Rückätzen werden an den Flanken der ersten Wortleitungen WL1' Spacer 31 gebildet. Das Rückätzen erfolgt zum Beispiel mit CHF₃.

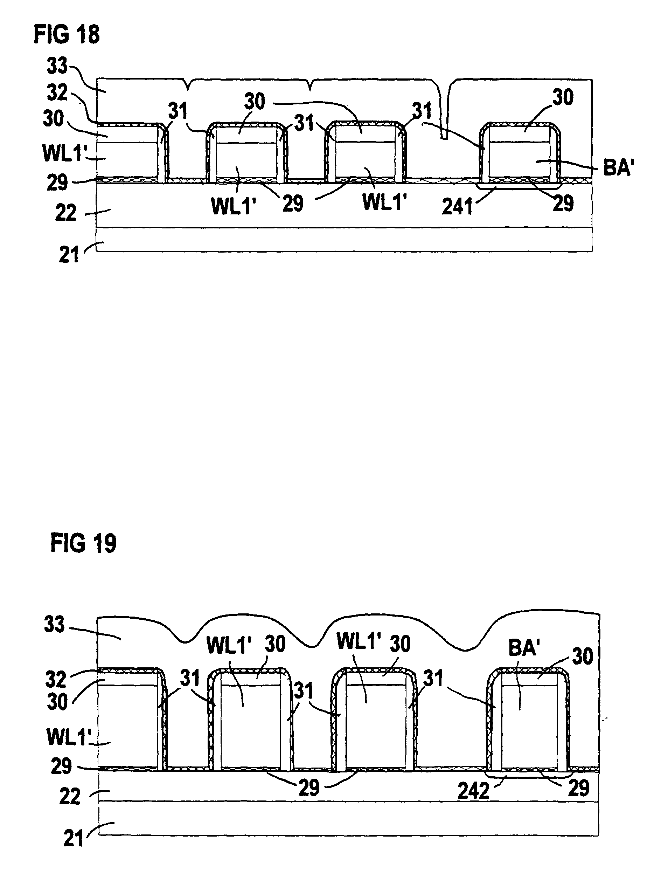

Zur Verbesserung der Kristallqualität wird anschließend eine Opferschicht aus Siliziumoxid (sogenanntes sacrificial oxid) erzeugt und abgeätzt (nicht dargestellt). Dann wird ganzflächig eine zweite dielektrische Schicht 32 aufgebracht (siehe Figur 18 in der der Schnitt A-A dargestellt ist, und Figur 19, in der der Schnitt B-B dargestellt ist). Die zweite dielektrische Schicht 32 wird zum Beispiel als Dreifachschicht mit einer ersten SiO₂-Schicht, einer Si₃N₄-Schicht und einer zweiten SiO₂-Schicht gebildet. Die Dicken dieser Schichten entsprechen den Dicken in der ersten dielektrischen Schicht 29.

Darauf wird eine zweite Elektrodenschicht 33 abgeschieden. Die zweite Elektrodenschicht 33 wird zum Beispiel aus dotiertem Polysilizium in einer Schichtdicke von 0,4 um gebildet. Dadurch füllt sie die Zwischenräume zwischen benachbarten ersten Wortleitungen WL1' vollständig auf. Die zweite Elektrodenschicht 33 wird zum Beispiel durch in situ dotierte Abscheidung von n-dotiertem Polysilizium oder durch undotierte Abscheidung von Polysilizium und anschließender Dotierung durch Implantation oder Diffusion gebildet. Alternativ kann die zweite Elektrodenschicht 33 aus Metall, Metallsilizid oder einem ähnlichen leitfähigen Material, das als Gateelektrode bzw. Wortleitung geeignet ist, gebildet werden.

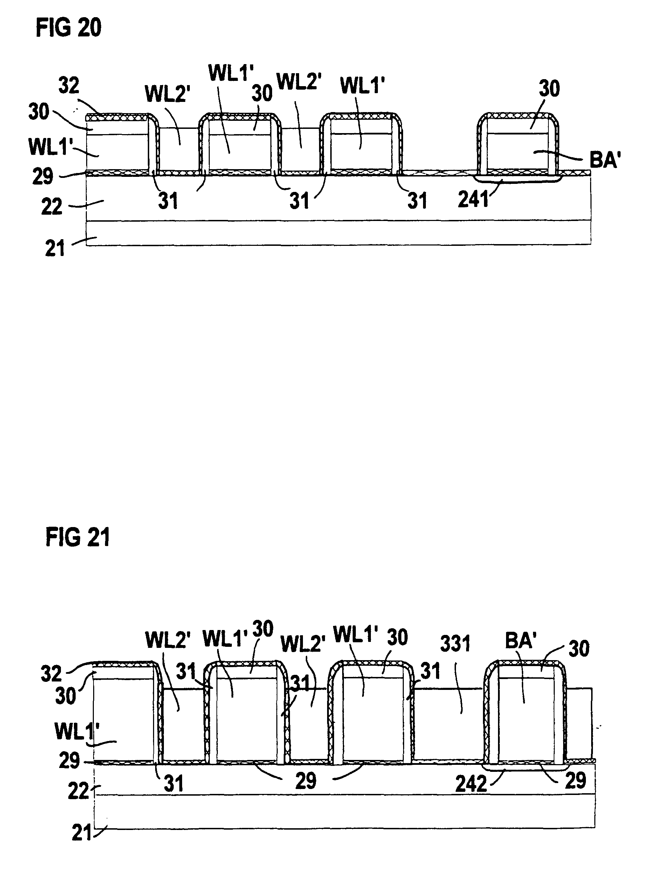

Durch isotropes Rückätzen der zweiten Elektrodenschicht 33 selektiv zur zweiten dielektrischen Schicht 32 werden die zweiten Wortleitungen WL2' gebildet. Die Ätzung erfolgt zum Beispiel mit CF₄/O₂. Die Ätzung wird überzogen, so daß die Oberfläche der zweiten dielektrischen Schicht 32 zwischen benachbarten Gräben und zwischen den Bitauswahlleitungen BA' und der diesen benachbarten ersten Wortleitung WL1' freigelegt wird. Am Grabenboden verbleibt dagegen zwischen den Bitauswahlleitungen BA' und der diesen benachbarten ersten Wortleitung WL1' ein Ätzrest 331 (siehe Figur 20, in der der Schnitt A-A zwischen benachbarten Gräben dargestellt ist, und Figur 21, in der der Schnitt B-B am Grabenboden dargestellt ist).

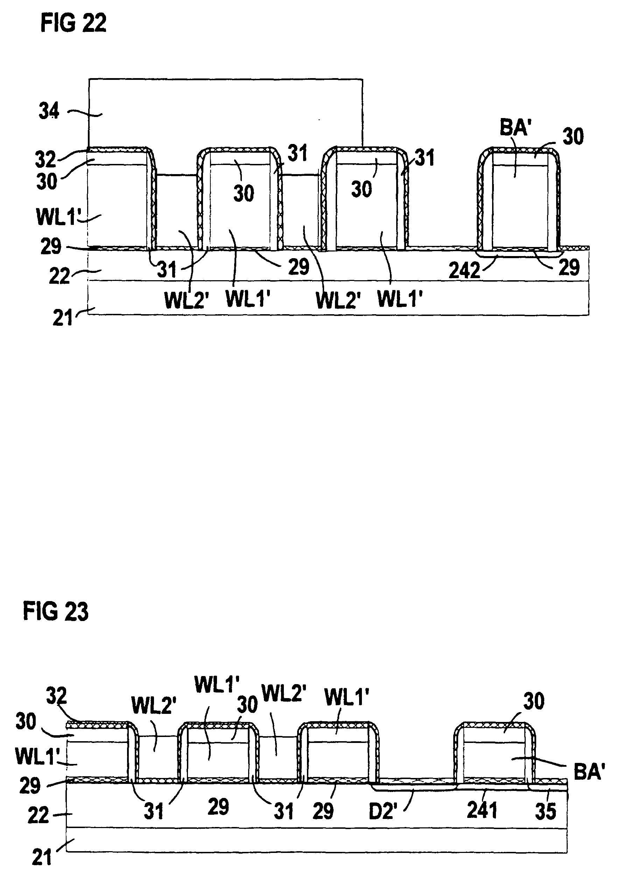

Anschließend wird eine Photolackmaske 34 gebildet, die das Zellenfeld abdeckt. Durch anisotropes Ätzen wird der Ätzrest 331 am Grabenboden zwischen dem Zellenfeld und den Bitauswahlleitungen BA' entfernt. Das Rückätzen erfolgt zum Beispiel mit HBr/Cl₂ (siehe Figur 22, in der der Schnitt B-B dargestellt ist).

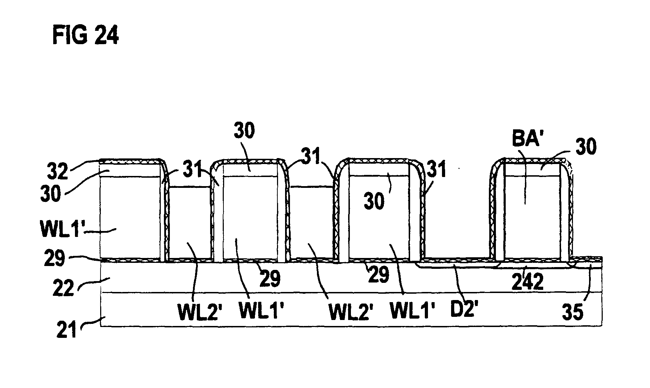

Nach Entfernen der Photolackmaske 34 wird eine Implantation mit zum Beispiel n-dotierenden Ionen durchgeführt zur Bildung der ersten dotierten Gebiete D1', der zweiten dotierten Gebiete D2', des Diffusionskontaktes DI' sowie der Source/Drain-Gebiete 35 der MOS-Transistoren des Dekoders (siehe Figur 9, Figur 23, in der der Schnitt A-A dargestellt ist und Figur 24, in der Schnitt B-B dargestellt ist). Die Implantation erfolgt zum Beispiel mit As mit einer Energie von 80 keV und einer Dosis von 5 x 10¹⁵ cm⁻².

Es liegt im Rahmen der Erfindung, die Implantation zweistufig im Sinne einer LDD und HDD-Implantation durchzuführen.

Die Speicherzellenanordnung wird durch Abscheidung eines Zwischenoxids, Kontaktlochätzungen und Aufbringen und Strukturieren einer Metallschicht fertiggestellt. Diese bekannten Prozeßschritte sind nicht dargestellt.

Die Erfindung ist nicht auf die beschriebenen Ausführungsbeispiele beschränkt. Insbesondere können die Leitfähigkeitstypen n und p vertauscht werden.

Ferner liegt es im Rahmen der Erfindung, für die erste dielektrische Schicht 15, 29 und die zweite dielektrische Schicht 18, 32 jeweils eine Mehrfachschicht, in der mindestens eine Schicht vorgesehen ist, die im Vergleich mit mindestens einer weiteren Schicht in der Mehrfachschicht einen erhöhten Ladungsträgereinfangquerschnitt aufweist, aus anderen Materialien zu verwenden, wobei die Schicht mit dem erhöhten Ladungsträgereinfangquerschnitt zum Beispiel aus Si₃N₄, TA₂O₅, Al₂O₃ oder aus TiO₂ besteht und die benachbarte Schicht aus SiO₂, Si₃N₄ oder Al₂O₃ bestehen. Ferner können die erste dielektrische Schicht 15, 29 und die zweite dielektrische Schicht 18, 32 eine dielektrische Schicht zum Beispiel aus SiO₂ enthalten, in die Fremdatome, zum Beispiel W, Pt, Cr, Ni, Pd, oder Ir eingelagert sind. Die eingelagerten Fremdatome können durch Implantation, durch Zugabe bei einer Oxidation oder durch Diffusion eingebracht werden.

Die Programmierung der Speicherzellenanordnung erfolgt durch Füllen der Haftstellen in der ersten dielektrischen Schicht 15, 29 bzw. der zweiten dielektrischen Schicht 18, 32 mittels Injektion von Elektronen. Dadurch wird die Einsatzspannung, bei der sich unterhalb der jeweiligen Wortleitung, die als Gateelektrode wirkt, ein leitender Kanal bildet, erhöht. Der jeweilige Wert der Einsatzspannungserhöhung läßt sich über Zeit und Größe der angelegten Spannung während der Programmierung einstellen.

Die Programmierung der Speicherzellenanordnung kann sowohl durch Fowler-Nordheim-Tunneln von Elektronen als auch durch Hot-Electron-Injection erfolgen.

Zum Einschreiben der Information durch Fowler-Nordheim-Tunneln wird die zu programmierende Speicherzelle über die zugehörige Wortleitung und Bitleitung ausgewählt. Die Bitleitung der Speicherzelle wird auf niedriges Potential gelegt, zum Beispiel auf 0 Volt. Die zugehörige Wortleitung wird dagegen auf hohes Potential gelegt, zum Beispiel auf Vₚᵣ = 12 Volt. Die anderen Bitleitungen werden auf ein Potential VBL angehoben, das so bemessen wird, daß Vₚᵣ - V_{BL} deutlich unterhalb der Programmierspannung Vₚᵣ liegt. Die anderen Wortleitungen werden auf ein Potential V_{WL} größer gleich V_{BL} + V_{T} angehoben, wobei V_{T} die Schwellenspannung bedeutet. Da sich bei der Programmierung alle anderen Bitleitungen, die die ausgewählte Wortleitung kreuzen, auf höherem Potential befinden, werden die anderen Speicherzellen, die mit der ausgewählten Wortleitung verbunden sind, nicht programmiert. Die Speicherzellen sind in einer NAND-Konfiguration verschaltet. Sie können daher so beschaltet werden, daß kein Drainstrom durch die Speicherzellen fließt. Das hat den Vorteil, daß der gesamte Programmiervorgang sehr leistungsarm verläuft.

Erfolgt die Programmierung durch Hot-Electron-Injection, so muß an den zu programmierenden MOS-Transistor die Sättigungsspannung angelegt werden. Dazu wird die der Speicherzelle zugeordnete Bitleitung zwischen Erdpotential und ein hohes Potential, zum Beispiel V_{BLpr} = 6 Volt gelegt. Die der Speicherzelle zugeordnete Wortleitung wird auf ein Potential gelegt, bei dem sich der MOS-Transistor im Sättigungsbetrieb befindet. Die Spannung V_{WLpr} an der Wortleitung ist kleiner als V_{BLpr}, zum Beispiel V_{WLpr} = 4 Volt. Die anderen Wortleitungen werden auf ein hohes Potential gelegt, das höher ist als V_{BLpr} und V_{WLpr}, zum Beispiel V_{WL} = 7 Volt. Diese Spannung wird in Abhängigkeit von der Dicke des Gatedielektrikums so gewählt, daß noch kein Fowler-Nordheim-Tunneln auftritt. Alle anderen Bitleitungen werden an beiden Enden auf gleiches Potential, zum Beispiel auf V_{BL} = V_{WLpr}/2 gelegt. Damit wird eine Programmierung von Speicherzellen, die entlang der ausgewählten Wortleitung an anderen Bitleitungen liegen, unterbunden und ein Stromfluß vermieden. Durch den Sättigungsbetrieb bei hoher Spannung entstehen im Kanalbereich des MOS-Transistors der ausgewählten Speicherzelle heiße Elektronen, die teilweise in das Gatedielektrikum injiziert werden. Die Elektronen werden von Haftstellen im Gatedielektrikum festgehalten und erhöhen die Schwellenspannung des MOS-Transistors. Je nach in der jeweiligen Speicherzelle einzuspeichernder Information wird auf diese Weise die Schwellenspannung des jeweiligen MOS-Transistors gezielt verändert.

Die Speicherzelle wird in einer "NAND"-Architektur betrieben. Das heißt, in einer Speicherzellenzeile werden die nicht ausgewählten Wortleitungen WL1, WL2 bzw. WL1', WL2' mit einer Spannung beaufschlagt, bei der das Kanalgebiet leitet, unabhängig von der vorhandenen Ladung im Gatedielektrikum. Wird die Speicherzellenanordnung so programmiert, daß sie zwei unterschiedliche Einsatzspannungswerte aufweist, so wird die ausgewählte Gateelektrode mit einer Spannung beaufschlagt, die zwischen dem ersten Einsatzspannungswert und dem zweiten Einsatzspannungswert liegt. Es wird bewertet, ob ein Strom über die Speicherzellenzeile fließt.

## Patentansprüche

1. Speicherzellenanordnung,
- bei der in einem Halbleitersubstrat (11) mehrere Speicherzellenzeilen angeordnet sind,
- bei der benachbarte Speicherzellenzeilen gegeneinander isoliert sind,
- bei der die Speicherzellenzeilen am Anfang und am Ende nur jeweils ein erstes dotiertes Gebiet (D1) entsprechend einem Source-/Drain-Gebiet und ein zweites dotiertes Gebiet (D2) entsprechend einem Source-/Drain-Gebiet aufweisen, zwischen denen an einer Hauptfläche des Halbleitersubstrates (11) ein Gatedielektrikum (15, 18), das ein Material mit Ladungsträger-Haftstellen enthält, und mehrere nebeneinander angeordnete Gateelektroden (WL1, WL2) angeordnet sind,
- bei der der Abstand benachbarter Gateelektroden (WL1, WL2) geringer als die Abmessungen der Gateelektroden (WL1, WL2) parallel zu der Verbindungslinie zwischen dem ersten dotierten Gebiet (D1) und dem zweiten dotierten Gebiet (D2) sind.

2. Speicherzellenanordnung nach Anspruch 1,
- bei der in der Hauptfläche des Halbleitersubstrates (21) parallele, streifenförmige Gräben (26) vorgesehen sind,
- bei der die Speicherzellenzeilen jeweils abwechselnd am Boden der Gräben (26) und zwischen benachbarten Gräben (26) an der Hauptfläche angeordnet sind.

3. Speicherzellenanordnung nach Anspruch 1,
bei der zur Isolation zwischen benachbarten Speicherzellenzeilen im Halbleitersubstrat (11) isolierende Gräben (T) vorgesehen sind.

4. Speicherzellenanordnung nach einem der Ansprüche 1 bis 3, bei der das Gatedielektrikum jeweils eine dielektrische Mehrfachschicht umfaßt mit mindestens einer Schicht, die im Vergleich mit mindestens einer weiteren Schicht einen erhöhten Ladungsträgereinfangsquerschnitt aufweist.

5. Speicherzellenanordnung nach Anspruch 4,
- bei der die Schicht mit erhöhtem Ladungsträgereinfangsquerschnitt mindestens einen der Stoffe Si₃N₄, Ta₂O₅, Al₂O₃ oder TiO₂ umfaßt,
- bei der die weitere Schicht mindestens einen der Stoffe SiO₂, Si₃N₄ oder Al₂O₃ umfaßt

6. Speicherzellenanordnung nach einem der Ansprüche 1 bis 3, bei der das Gatedielektrikum jeweils eine dielektrische Schicht mit eingelagerten Fremdatomen umfaßt, wobei die eingelagerten Fremdatome im Vergleich mit der dielektrischen Schicht einen erhöhten Ladungsträgereinfangsquerschnitt aufweisen.

7. Speicherzellenanordnung nach Anspruch 6,
- bei der die dielektrische Schicht SiO₂ enthält,
- bei der die eingelagerten Fremdatome mindestens eines der Elemente W, Pt, Cr, Ni, Pd, oder Ir enthalten.

8. Verfahren zur Herstellung einer Speicherzellenanordnung,
- bei dem in einem Halbleitersubstrat (11) mehrere Speicherzellenzeilen erzeugt werden, die gegeneinander isoliert werden,
- bei dem für jede Speicherzellenzeile am Anfang und am Ende der jeweiligen Speicherzeile in dem Halbleitersubstrat (11) nur ein erstes dotiertes Gebiet (D1) entsprechend einem Source-/Drain-Gebiet und ein zweites dotiertes Gebiet (D2) entsprechend einem Source-/Drain-Gebiet gebildet werden,
- bei dem zwischen dem ersten dotierten Gebiet (D1) und dem zweiten dotierten Gebiet (D2) an einer Hauptfläche des Halbleitersubstrats (11) ein Gatedielektrikum (15, 18), das aus einem Material mit Ladungsträger-Haftstellen erzeugt wird, und mehrere nebeneinander angeordnete Gateelektroden (WL1, WL2) so erzeugt werden, daß der Abstand zwischen benachbarten Gateelektroden (WL1, WL2) geringer ist als die Abmessungen der Gateelektroden (WL1, WL2) parallel zu der Verbindungslinie zwischen dem ersten dotierten Gebiet (D1) und dem zweiten dotierten Gebiet (D2).

9. Verfahren nach Anspruch 8,
- bei dem das Gatedielektrikum (15, 18) jeweils als Mehrfachschicht mit mindestens einer Schicht, die im Vergleich mit mindestens einer weiteren Schicht einen erhöhten Ladungsträgereinfangsquerschnitt aufweist, gebildet wird.

10. Verfahren nach Anspruch 9,
- bei dem die Schicht mit erhöhtem Ladungsträgereinfangsquerschnitt mindestens einen der Stoffe Si₃N₄, Ta₂O₅, Al₂O₃ oder TiO₂ umfaßt,
- bei dem die weitere Schicht mindestens einen der Stoffe SiO₂, Si₃N₄ oder Al₂O₃ umfaßt

11. Verfahren nach Anspruch 8,
bei dem das Gatedielektrikum (15, 18) jeweils als dielektrische Schicht mit eingelagerten Fremdatomen gebildet wird, wobei die eingelagerten Fremdatome im Vergleich mit der dielektrischen Schicht einen erhöhten Ladungsträgereinfangsquerschnitt aufweisen.

12. Verfahren nach Anspruch 11,
- bei dem die dielektrische Schicht SiO₂ umfaßt,
- bei dem die eingelagerten Fremdatome mindestens eines der Elemente W, Pt, Cr, Ni, Pd, oder Ir enthalten.

13. Verfahren nach einem der Ansprüche 8 bis 12,
- bei dem eine erste dielektrische Schicht (15) gebildet wird,
- bei dem eine erste Elektrodenschicht erzeugt und zur Bildung erster Gateelektroden (WL1) strukturiert wird,
- bei dem an den Flanken der ersten Gateelektroden (WL1) Spacer (17) gebildet werden,
- bei dem eine zweite dielektrische Schicht (18) gebildet wird,
- bei dem zur Bildung zweiter Gateelektroden (WL2) eine zweite Elektrodenschicht (19) mit im wesentlichen konformer Kantenbedeckung erzeugt und strukturiert wird.

14. Verfahren nach Anspruch 13,
- bei dem die Spacer (17) zwischen den ersten Gateelektroden (WL1) und den zweiten Gateelektroden (WL2) selektiv zu den ersten Gateelektroden (WL1) und den zweiten Gateelektroden (WL2) entfernt werden,
- bei dem durch eine Gegendotierung die Dotierung des Halbleitersubstrats im Bereich zwischen den ersten Gateelektroden (WL1) und den zweiten Gateelektroden (WL2) moduliert wird.

15. Verfahren nach einem der Ansprüche 12 bis 14, bei dem in der Hauptfläche des Halbleitersubstrats (11) streifenförmige Isolationsgräben (T) gebildet werden, die jeweils zwischen benachbarten Speicherzellenzeilen angeordnet sind.

16. Verfahren nach einem der Ansprüche 12 bis 14,
- bei dem in der Hauptfläche des Halbleitersubstrates (21) streifenförmige, im wesentlichen parallele Gräben (26) gebildet werden,
- bei dem die Speicherzellenzeilen jeweils abwechselnd am Boden der Gräben (26) und an der Hauptfläche zwischen benachbarten Gräben (26) gebildet werden.

## Claims

1. Memory cell arrangement,
- in which a plurality of memory cell rows are arranged in a semiconductor substrate (11),
- in which adjacent memory cell rows are insulated from one another,
- in which the memory cell rows have at the beginning and at the end only in each case a first doped region (D1) corresponding to a source/drain region and a second doped region (D2) corresponding to a source/drain region, between which are arranged, on a main area of the semiconductor substrate (11), a gate dielectric (15, 18), which contains a material having large carrier traps, and a plurality of gate electrodes (WL1, WL2) arranged next to one another,
- in which the distance between adjacent gate electrodes (WL1, WL2) is smaller than the dimensions of the gate electrodes (WL1, WL2) parallel to the connecting line between the first doped region (D1) and the second doped region (D2).

2. Memory cell arrangement according to Claim 1,
- in which parallel, strip-type trenches (26) are provided in the main area of the semiconductor substrate (21),
- in which the memory cell rows are arranged in each case alternately on the bottom of the trenches (26) and between adjacent trenches (26) on the main area.

3. Memory cell arrangement according to Claim 1, in which insulating trenches (T) are provided for the purpose of insulation between adjacent memory cell rows in the semiconductor substrate (11).

4. Memory cell arrangement according to one of Claims 1 to 3,
in which the gate dielectric in each case comprises a dielectric multiple layer having at least one layer which has an increased charge carrier capture cross-section in comparison with at least one further layer.

5. Memory cell arrangement according to Claim 4,
- in which the layer having an increased charge carrier capture cross-section comprises at least one of the substances Si₃N₄, Ta₂O₅, Al₂O₃ or TiO₂,
- in which the further layer comprises at least one of the substances SiO₂, Si₃N₄ or Al₂O₃.

6. Memory cell arrangement according to one of Claims 1 to 3,
in which the gate dielectric in each case comprises a dielectric layer having incorporated impurity atoms, the incorporated impurity atoms having an increased charge carrier capture cross-section in comparison with the dielectric layer.

7. Memory cell arrangement according to Claim 6,
- in which the dielectric layer contains SiO₂,
- in which the incorporated impurity atoms contain at least one of the elements W, Pt, Cr, Ni, Pd or Ir.

8. Method for fabricating a memory cell arrangement,
- in which a plurality of memory cell rows are produced in a semiconductor substrate (11), the said memory cell rows being insulated from one another,
- in which, for each memory cell row, only a first doped region (D1) corresponding to a source/drain region and a second doped region (D2) corresponding to a source/drain region are formed at the beginning and at the end of the respective memory row in the semiconductor substrate (11),
- in which, between the first doped region (D1) and the second doped region (D2) on a main area of the semiconductor substrate (11), a gate dielectric (15, 18), which is produced from a material having charged carrier traps, and a plurality of gate electrodes (WL1, WL2) arranged next to one another are produced in such a way that the distance between adjacent gate electrodes (WL1, WL2) is smaller than the dimensions of the gate electrodes (WL1, WL2) parallel to the connecting line between the first doped region (D1) and the second doped region (D2).

9. Method according to Claim 8,
- in which the gate dielectric (15, 18) is in each case formed as a multiple layer having at least one layer which has an increased charge carrier capture cross-section in comparison with at least one further layer.

10. Method according to Claim 9,
- in which the layer having an increased charge carrier capture cross-section comprises at least one of the substances Si₃N₄, Ta₂O₅, Al₂O₃ or TiO₂,
- in which the further layer comprises at least one of the substances SiO₂, Si₃N₄ or Al₂O₃.

11. Method according to Claim 8,
in which the gate dielectric (15, 18) is in each case formed as a dielectric layer having incorporated impurity atoms, the incorporated impurity atoms having an increased charge carrier capture cross-section in comparison with the dielectric layer.

12. Method according to Claim 11,
- in which the dielectric layer contains SiO₂,
- in which the incorporated impurity atoms contain at least one of the elements W, Pt, Cr, Ni, Pd or Ir.

13. Method according to one of Claims 8 to 12,
- in which a first dielectric layer (15) is formed,
- in which a first electrode layer is produced and patterned in order to form first gate electrodes (WL1),
- in which spacers (17) are formed on the sidewalls of the first gate electrodes (WL1),
- in which a second dielectric layer (18) is formed,
- in which, in -order to form second gate electrodes (WL2), a second electrode layer (19) is produced with essentially conformal edge coverage and patterned.

14. Method according to Claim 13,
- in which the spacers (17) between the first gate electrodes (WL1) and the second gate electrodes (WL2) are removed selectively with respect to the first gate electrodes (WL1) and the second gate electrodes (WL2),
- in which, by means of a counterdoping, the doping of the semiconductor substrate is modulated in the region between the first gate electrodes (WL1) and the second gate electrodes (WL2).

15. Method according to one of Claims 12 to 14,
in which strip-type isolation trenches (T) are formed in the main area of the semiconductor substrate (11), the said trenches in each case being arranged between adjacent memory cell rows.

16. Method according to one of Claims 12 to 14,
- in which strip-type, essentially parallel trenches (26) are formed in the main area of the semiconductor substrate (21),
- in which the memory cell rows are formed in each case alternately on the bottom of the trenches (26) and on the main area between adjacent trenches (26).

## Revendications

1. Dispositif de cellules de mémoire,
- dans lequel plusieurs lignes de cellules de mémoire sont disposées dans un substrat (11) semi-conducteur,
- dans lequel des lignes de cellules de mémoire voisines sont isolées les unes des autres,
- dans lequel les lignes de cellules de mémoire ne comportent au début et à la fin respectivement qu'une première région D1 dopée correspondant à une région de source/drain et une deuxième région D2 dopée correspondant à une région de source/drain, un diélectrique (15, 18) de grille, qui contient un matériau à piège de porteur de charge, et plusieurs électrodes (WL1, WL2) de grille disposés côte-à-côte étant disposés entre les régions dopées sur une surface principale du substrat (11) semi-conducteur,
- dans lequel la distance entre des électrodes (WL1, WL2) de grille voisines est inférieure aux dimensions des électrodes (WL1, WL2) de grille parallèlement à la ligne de liaison entre la première région (D1) dopée et la deuxième région (D2) dopée.

2. Dispositif de cellules de mémoire suivant la revendication 1,
- dans lequel il est prévu dans la surface principale du substrat (21) semi-conducteur des sillons (26) parallèles en forme de bande,
- dans lequel les lignes de cellules de mémoire sont disposées chaque fois alternativement au fond des sillons (26) et entre les sillons (26) voisins, sur la surface principale.

3. Dispositif de cellules de mémoire suivant la revendication 1,
dans lequel il est prévu des sillons (T) isolants dans le substrat (11) semi-conducteur pour l'isolement entre des lignes de cellules de mémoire voisines.

4. Dispositif de cellules de mémoire suivant l'une des revendications 1 à 3 dans lequel, le diélectrique de grille comprend chaque fois une multicouche diélectrique comportant au moins une couche qui a, comparée à au moins une autre couche, une section transversale accrue de piégeage de porteurs de charge.

5. Dispositif de cellules de mémoire suivant la revendication 4,
- dans lequel la couche ayant la section transversale accrue de piégeage de porteurs de charge comprend au moins une des substances Si₃N₄, TA₂O₅, Al₂O₃ ou TiO₂,
- dans lequel la couche supplémentaire comporte au moins l'une des substances SiO₂, Si₃N₄ ou Al₂O₃.

6. Dispositif de cellules de mémoire suivant l'une des revendications 1 à 3, dans lequel le diélectrique de grille comprend chaque fois une couche diélectrique comportant des atomes étrangers incorporés, les atomes étrangers incorporés ayant, comparés à la couche diélectrique, une section transversale accrue de piégeage de porteurs de charge.

7. Dispositif de cellules de mémoire suivant la revendication 3,
- dans lequel la couche diélectrique contient du SiO₂,
- dans lequel les atomes étrangers incorporés contiennent au moins l'un des éléments W, Pt, Cr, Ni, Pd, ou Ir.

8. Procédé pour produire un dispositif de cellules de mémoire
- dans lequel on produit dans un substrat (11) semi-conducteur plusieurs lignes de cellules de mémoire qui sont isolées les unes des autres,
- dans lequel on forme pour chaque ligne de cellules de mémoire, au début et à la fin de la ligne de mémoire associée, dans le substrat (11) semi-conducteur, seulement une première région (D1) dopée correspondant à une région de source/drain et une deuxième région (D2) dopée correspondant à une région de source/drain,
- dans lequel on produit entre la première région (D1) dopée et la deuxième région (D2) dopée, sur une surface principale du substrat (11) semi-conducteur, un diélectrique (15, 18) de grille qui est en un matériau comportant des pièges de porteurs de charge et plusieurs électrodes de grille disposées côte-à-côte, de telle manière que la distance entre des électrodes (WL1, WL2) de grille voisines est inférieure aux dimensions des électrodes (WL1, WL2) de grille parallèlement à la ligne de liaison entre la première région (D1) dopée et la deuxième région (D2) dopée.

9. Procédé suivant la revendication 8,
- dans lequel on forme le diélectrique (15, 18) de grille chaque fois en triple couche comportant au moins une couche qui a, comparé à au moins une autre couche, une section transversale accrue de piégeage de porteurs de charge.

10. Procédé suivant la revendication 9,
- dans lequel la couche à section transversale accrue de piégeage de porteurs de charge comprend au moins l'une des substances Si₃N₄, Ta₂O₅, Al₂O₃ ou TiO₂,
- dans lequel la couche supplémentaire comprend au moins une des substances SiO₂, Si₃N₄, ou Al₂O₃.

11. Procédé suivant la revendication 9,
- dans lequel on forme le diélectrique (15, 18) de grille chaque fois en couche diélectrique à atomes étrangers incorporés, les atomes étrangers incorporés ayant, comparés à la couche diélectrique, une section transversale accrue de piégeage de porteurs de charge.

12. Procédé suivant la revendication 11,
- dans lequel la couche diélectrique comprend du SiO₂,
- dans lequel les atomes étrangers incorporés contiennent au moins l'un des éléments W, Pt, Cr, Ni, Pd ou Ir.

13. Procédé suivant l'une des revendications 8 à 12,
- dans lequel on forme une première couche (15) diélectrique,
- dans lequel on produit une première couche d'électrodes et on la structure pour former de premières électrodes (WL1) de grille,
- dans lequel on forme des espaceurs (17) sur les flancs des premières électrodes (WL1) de grille,
- dans lequel on forme une deuxième couche (18) diélectrique,
- dans lequel on produit et on structure, pour former des deuxièmes électrodes (WL2) de grille, une deuxième couche (19) d'électrode ayant un revêtement d'arête sensiblement conforme.

14. Procédé suivant la revendication 13,
- dans lequel on enlève les espaceurs (17) entre les premières électrodes (WL1) de grille et les deuxièmes électrodes (WL2) de grille de manière sélective par rapport aux premières électrodes (WL1) de grille et aux deuxièmes électrodes (WL2) de grille,
- dans lequel on module par un contre-dopage le dopage du substrat semi-conducteur dans la zone entre les premières électrodes (WL1) de grille et les deuxièmes électrodes (WL2) de grille.

15. Procédé suivant l'une des revendications 12 à 14,
dans lequel on forme dans la surface principale du substrat (11) semi-conducteur des sillons (T) isolants en forme de bande qui sont disposés chaque fois entre des lignes de cellules de mémoire voisines.

16. Procédé suivant l'une des revendications 12 à 14,
- dans lequel on forme dans la surface principale du substrat (21) semi-conducteur des sillons (26) en forme de bande sensiblement parallèles,
- dans lequel on forme les lignes de cellules de mémoire chaque fois alternativement au fond des sillons (26) et sur la surface principale entre des sillons (26) voisins.
